# EUROPEAN PATENT SPECIFICATION

(11) **EP 2 267 723 B1**
(45) Date of publication and mention of the grant of the patent: **04.06.2014**
(21) Application number: 10177225.9
(22) Date of filing: 27.09.2000
(51) Int. Cl.: G11C 11/406, G11C 5/14, G11C 14/00

(54) **Semiconductor memory device and method of controlling the same**
Halbleiterspeichervorrichtung und Steuerverfahren dafür
Dispositif mémoire à semi-conducteur et son procédé de commande

(30) Priority: 09.11.1999 JP 31845899; 09.08.2000 JP 2000241019
(43) Date of publication of application: 29.12.2010
(62) Divisional of application: 10165897.9
(73) Proprietor: Fujitsu Semiconductor Limited, Kohoku-ku, Yokohama-shi Kanagawa 222-0033 (JP)
(72) Inventor: Fujioka, Shinya, Kawasaki-shi Kanagawa 211-8588 (JP); Kawakubo, Tomohiro, Kawasaki-shi Kanagawa 211-8588 (JP); Nishimura, Koichi, Kawasaki-shi Kanagawa 211-8588 (JP); Sato, Kotoku, Kawasaki-shi Kanagawa 211-8588 (JP)
(74) Representative: Fenlon, Christine Lesley

(56) References cited:
- EP-A- 0 566 306
- US-A- 5 875 143

## Description

The present invention relates to a semiconductor memory device having a low power consumption mode.

US 5875143 A refers to a dynamic memory device with refresh circuit and a refresh method. The refresh circuit and the method for the refresh of dynamic memory devices are described where the rows to be refreshed are determined by a logical function and by a reference address. The availability of refresh signals for the rows at the outputs of a decoder is determined by control logic which is connected to an address generator and to a reference register which contains a reference address. By supplying the reference address to the refresh circuit it is determined which rows are to be refreshed. The memory array of the dynamic memory device is refreshed partially.

EP 0566306 A2 refers to a semiconductor memory device. The semiconductor memory device which is packaged in one package, comprises: a volatile memory formed on one semiconductor substrate and including a plurality of first memory cells, wherein each of said first memory cells has one MOSFET and one capacitor; and a nonvolatile memory formed on one semiconductor substrate and including a plurality of second memory cells, wherein each of said second memory cells has a source, a drain, and a floating gate and a control gate over a channel region formed between said source and said drain.

In recent years, the cellular phone has been given not only a function to have a vocal communication but also a function to transmit character-string data or image data. Moreover, the cellular phone is expected in the future to become a kind of information terminal (for example, a portable type personal computer) as the internet services are diversified. Thus, the information volume of data to be handled by the cellular phone has been drastically increasing. Typically, the cellular phone has employed as its work memory SRAMs having a memory capacity of about 4 Mbit. The work memory is a memory for retaining the necessary data during the operation of the cellular phone. It is probable that the memory capacity of this work memory will be insufficient in the future.

In addiction, the transmission speed of the cellular phone has been increasing. The smaller the cellular phone becomes, the smaller the battery to be mounted becomes. Therefore, the work memory to be employed in the cellular phone is required to have a high speed, a low power consumption and a large capacity. Due to serious price competition in the cellular phone market, it is necessary to make the costs for parts as low as possible. Therefore, the work memory also has to be at low price.

The SRAMs employed in the work memory of previously-considered cellular phones are higher per bit in cost than DRAMs. The number of SRAMs produced is smaller than that of the DRAMs so that it is difficult to lower its price. Moreover, there have never been developed SRAMs having a large memory capacity (for example, 64 Mbit).

In this situation, it has been considered to replace the SRAMs by flash memories and DRAMs in the work memory of the cellular phone.

The flash memory has a power consumption as low as several µW during a standby state but requires several µs to several tens µs for writing data. When the flash memory is employed as the work memory of the cellular phone, therefore, it is difficult to transmit/receive massive data at high speed. The flash memory performs the write operation at the unit of a sector so that it is not suitable for rewriting image data, such as the data of a moving image, bit by bit.

On the contrary, the DRAMs can execute both the read operation and the write operation within several tens ns and can process the data of the moving image easily. However, the power consumption during the standby state is higher than that of the flash memories. In the present DRAMs, the power consumption in the standby state is about 1 mW during a self-refresh mode for retaining written data and about 300 W during a standby mode not required for retaining written data.

If the power consumption during the standby mode could be reduced to that of the flash memories, the DRAMs could be employed as the work memory of the cellular phone, but such circuit technology has never been proposed.

The power consumption of the DRAMs can be reduced to zero by stopping the power supply to the DRAMs. However, since the address terminals, the data terminals and the like of the DRAMs are connected with the terminals of other electronic parts through the wiring patterns on a circuit board, it is required to drastically change the system of the cellular phone (the pattern change of the circuit board, re-layout and so on) for the termination of the power supply to the DRAMs.

Besides, there has not been proposed a technology which realizes exit from the standby mode without the malfunction of an internal circuit after the power supply is terminated to stop the operation of the internal circuit during the standby mode.

It is therefore desirable to be able to enter the device into a low power consumption mode and exit the device from a low power consumption mode with reliability.

It is also desirable to provide a semiconductor memory device capable of drastically reducing current consumption during standby mode as compared with the previously-considered devices and a method of controlling the semiconductor memory device.

It is also desirable to provide a semiconductor memory device capable of drastically reducing current consumption during a standby period as compared with the conventional devices and a method of controlling the semiconductor memory device.

According to the present invention, there is provided a semiconductor memory device comprising:
a first memory including dynamic memory cells, the first memory being capable to enter a low power consumption mode in which the dynamic memory cells do not retain data therein by prohibiting refresh operations, and the first memory having a data terminal;
a second memory including flash memory cells, having a data terminal which is connected with the data terminal of the first memory, in which the first memory is capable to enter the low power consumption mode in response to a change from a first level to a second level of an external control signal received at an external terminal, the first memory being capable to receive the external control signal through a signal line, capable to continuously receive a power supply voltage during the low power consumption mode, and capable to exit the low power consumption mode in response to a change from the second level to the first level of the external control signal, and
an internal voltage generator for generating an internal voltage from an external voltage and for supplying the internal voltage to an internal circuit, the internal circuit voltage generator being deactivated in the low power consumption mode where the external voltage is applied to the internal circuit.

A semiconductor memory device, and a method of controlling the device, embodying the present invention can offer one or more of the following advantages:
It is possible to easily enter a device into a low power consumption mode by a control signal from the exterior.
It is possible to prevent the feedthrough current (or leak path) of an internal circuit during a lower power consumption mode.
It is possible to easily enter the device into the low power consumption mode by employing an existing control signal.
It is possible to easily enter the device into the low power consumption mode by a command input.
It is possible to easily enter the device into the low power consumption mode by a dedicated control signal.

Reference will now be made, by way of example, to the accompanying drawings, in which:
Fig. 1 is a state transition diagram of a semiconductor memory device embodying the present invention;
Fig. 2 is a block diagram showing a basic principle of a first example;
Fig. 3 is a block diagram showing the first example;
Fig. 4 is a circuit diagram showing the details of a booster and a precharging voltage generator of Fig. 3;
Fig. 5 is a circuit diagram showing the details of an internal supply voltage generator and a substrate voltage generator of Fig. 3;
Fig. 6 is a circuit diagram showing the detail of a portion of a memory core of Fig. 3;
Fig. 7 is a timing chart showing the operations of the first example at the switch-on of a power supply and at the times of entry into and exit from a low power consumption mode;
Fig. 8 is a block diagram showing an example in which the semiconductor memory device of the first example is used in a cellular phone;
Fig. 9 is an explanatory diagram showing the state of using the cellular phone shown in Fig. 8;
Fig. 10 is a flow chart showing the state of controlling the cellular phone shown in Fig. 8;
Fig. 11 is a block diagram showing a second example;
Fig. 12 is a circuit diagram showing the detail of a low power entry circuit of Fig. 11;
Fig. 13 is a timing chart showing the operations of the low power entry circuit of Fig. 12;
Fig. 14 is a block diagram showing an embodiment;
Fig. 15 is a circuit diagram showing a VII starter in a third example;
Fig. 16 is a circuit diagram showing a VII starter in the third example;
Fig. 17 is a timing chart showing operations at the entry to and the exit from a low power consumption mode in the third example;
Fig. 18 is a circuit diagram showing a level detecting circuit in a fourth example;
Fig. 19 is a timing chart showing operations at the entry to and the exit from a low power consumption mode in the fourth example;
Fig. 20 is a circuit diagram showing a start signal generator in a fifth example; and
Fig. 21 is a timing chart showing operations at the entry to and the exit from a low power consumption mode in the fifth example.

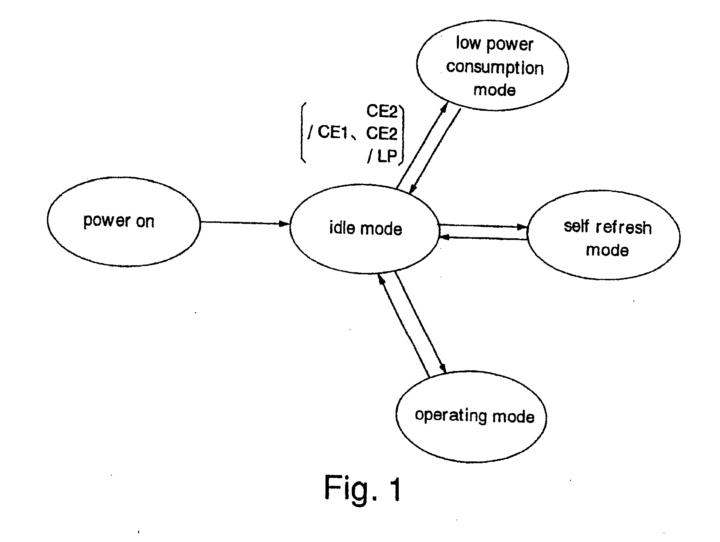

Examples and an embodiment of the present invention will be described with reference to the accompanying drawings. Fig. 1 shows a state transition diagram of a semiconductor memory device embodying the present invention.

First of all, the semiconductor memory device comes into an idle mode when the power supply is switched on. When a read command or a write command is received in the idle mode, the mode shifts to an operating mode to execute a read operation or a write operation. After the execution of the read operation or the write operation, the idle mode is automatically restored. When a self-refreshing command is received in the idle mode, the device enters the self-refreshing mode to execute self refresh. Herein the self-refreshing mode, a refresh address is automatically generated to sequentially execute refreshing operations in memory cells.

The semiconductor memory device enters the low power consumption mode by detecting a predetermined state of a signal in the idle mode. In a first example described below, in response to a chip enable signal CE2, the device enters the low power consumption mode. Specifically, by the chip enable signal CE2 a predetermined internal circuit is inactivated and the device enters the low power consumption mode. In a second example described below, in response to a command input by chip enable signals /CE1 and CE2, the device enters the low power consumption mode. In an embodiment described below, in response to a dedicated low power consumption mode signal /LP, the device enters the low power consumption mode.

The semiconductor memory device detects a predetermined state of a signal during the low power consumption mode and exits the mode.

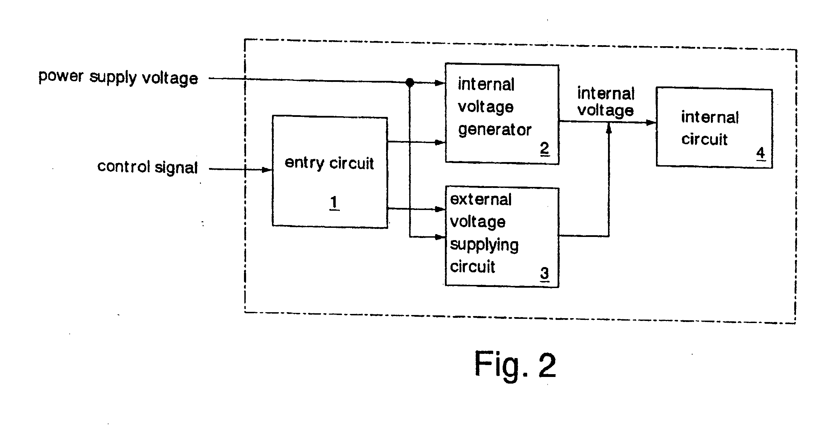

Fig. 2 shows the basic principle of a semiconductor memory device embodying the present invention.

The semiconductor memory device includes an entry circuit 1, an internal voltage generator 2, an external voltage supplying circuit 3 and an internal circuit 4.

The internal voltage generator 2 generates an internal voltage in each mode after the power supply is switched on, and supplies the internal voltage to the internal circuit 4. The entry circuit 1 receives a control signal and inactivates the internal voltage generator 2 when it detects a predetermined state of the control signal. When the internal voltage generator 2 is inactivated, the generation of the internal voltage is stopped. At the same time, the entry circuit 1 activates the external voltage supplying circuit 3. This external voltage supplying circuit 3 supplies the power supply voltage as the internal voltage to the internal circuit 4. And, the semiconductor memory device enters the low power consumption mode.

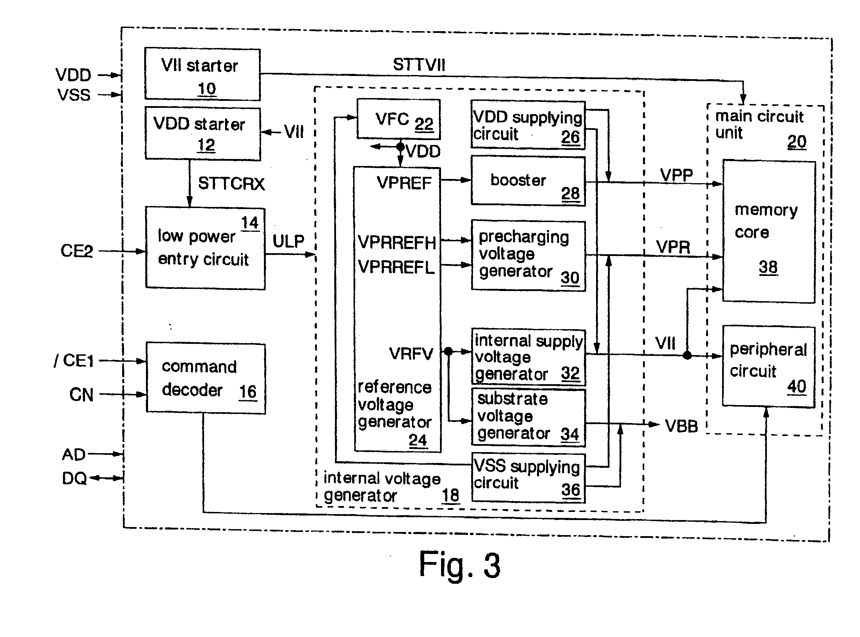

Fig. 3 shows a first example of the semiconductor memory device and its control method of the present invention. The semiconductor memory device of this example is formed as a DRAM on a p-type silicon substrate by employing the CMOS process technology.

The DRAM is provided with a VII starter 10, a VDD starter 12, a low power entry circuit 14, a command decoder 16, an internal voltage generator 18 and a main circuit unit 20. The internal voltage generator 18 has a low-pass filter 22, a reference voltage generator 24, a VDD supplying circuit 26, a booster 28, a precharging voltage generator 30, an internal supply voltage generator 32, a substrate voltage generator 34 and a VSS supplying circuit 36. The main circuit unit 20 has a memory core 38 and a peripheral circuit 40. Here, the low power entry circuit 14 corresponds to the entry circuit 1 shown in Fig. 2, and the VDD supplying circuit 26 and the VSS supplying circuit 36 correspond to the external voltage supplying circuit 3 shown in Fig. 2.

The DRAM is supplied with a power supply voltage VDD (e.g., 2.5 V) from the exterior, a ground voltage VSS, chip enable signals /CE1 and CE2 as the control signals, a plurality of address signal AD, a plurality of data input/output signals DQ, and another control signal CN. This DRAM does not adopt the address multiplex method. Therefore, the address signals AD is supplied once at each read operation and at each write operation. The power supply voltage VDD and the ground voltage VSS are supplied to almost all the circuits excepting a partial circuit of the memory core 38. Here, the signals headed by the letter "/" are those of negative logic. The "address signals AD" may be abbreviated into the "AD signals" in the following description by omitting its signal name.

The /CE1 signal is turned to a low level when the read operation and the write operation are executed to activate the DRAM. The CE2 signal functions as a reset signal to inactivate a predetermined internal circuit in the main circuit unit 20 when at the low level.

The VII starter 10 receives the internal supply voltage VII and the ground voltage VSS and outputs a start signal STTVII to the main circuit unit 20. The VII starter 10 is resets the main circuit unit 20 after the power supply is switched on until the internal supply voltage VII reaches a predetermined voltage, and it prevents the malfunction of the main circuit unit 20. The VDD starter 12 receives the power supply voltage VDD and the ground voltage VSS and outputs a start signal STTCRX. The VDD starter 12 inactivates the low power entry circuit 14 after the power supply is switched on until the power supply voltage VDD reaches a predetermined voltage and it prevents the malfunction of the circuit 14.

The low power entry circuit 14 receives the start signal STTCRX and the CE2 signal and activates a low power signal ULP.

In response to the /CE1 signal and another control signal CN, the command decoder 16 decodes a command and outputs the decoded command as an internal command signal to the peripheral circuit 40.

The low-pass filter 22 has a function to filter out the noise contained in the power supply voltage VDD. The power supply voltage VDD thus cleared of the noise is fed to the reference voltage generator 24 or the like. In the low power consumption mode, the switch in the low-pass filter 22 is switched off and the power supply voltage VDD is not supplied to the reference voltage generator 24 so that the current is not consumed.

The reference voltage generator 24 receives the power supply voltage VDD and generates reference voltages VPREF (e.g., 1.5 V), VPRREFL (e.g., 0.8 V), VPRREFH (e.g., 1.2 V) and VRFV (e.g., 2.0 V).

The VDD supplying circuit 26 turns a boost voltage VPP and an internal supply voltage VII to the power supply voltage VDD during the low power consumption mode.

The booster 28 receives the reference voltage VPREF and generates the boost voltage VPP (e.g., 3.7 V) and supplies the boost voltage VPP to the memory core 38.

The precharging voltage generator 30 receives the reference voltage VPRREFL and the reference voltage VPRREFH and generates a precharging voltage VPR (e.g., 1.0 V) to be supplied to the memory core 38.

The internal supply voltage generator 32 receives the reference voltage VRFV and generates the internal supply voltage VII (e.g., 2.0 V) to be supplied to the memory core 38 and the peripheral circuit 40.

The substrate voltage generator 34 receives the reference voltage VRFV and generates a substrate voltage VBB (e.g., -1.0 V) to be fed to the substrate and the p-wells of the memory cells.

The VSS supplying circuit 36 turns the precharging voltage VPR and the substrate voltage VBB to the ground voltage VSS during the low power consumption mode.

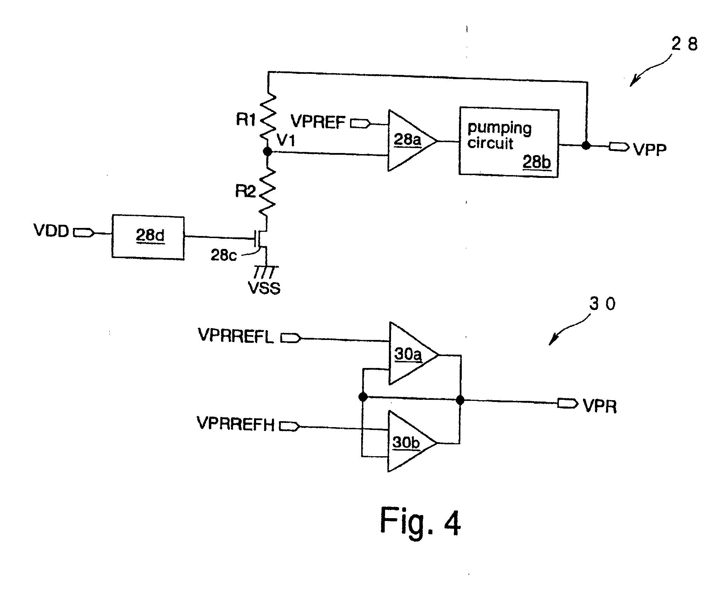

Fig. 4 shows the details of the booster 28 and the precharging voltage generator 30.

The booster 28 is composed of resistors R1 and R2 connected in series, a differential amplifier 28a, a pumping circuit 28b, an nMOS 28c and a switching circuit 28d for controlling the gate of the nMOS 28c. The resistor R1 is supplied at its one end with the boost voltage VPP, and the resistor R2 is supplied at its one end with the ground voltage VSS through the nMOS 28c. A divided voltage V1 is generated from the connection node of the resistors R1 and R2. The nMOS 28c receives the power supply voltage VDD from the switching circuit 28d during the low power consumption mode. The differential amplifier 28a is formed of a MOS differential amplifier using a current mirror circuit, for example, as the current source. The differential amplifier 28a outputs a high level when the voltage V1 is lower than the reference voltage VPREF. The pumping circuit 28b receives the high level from the differential amplifier 28a and starts a pumping operation. By this pumping operation, the voltage VPP is raised, and the voltage V1 is raised. When this voltage V1 coincides with the reference voltage VPREF (i.e., 1.5 V), the output of the differential amplifier 28a reaches the low level so that the pumping operation stops. By repeating these operations, the boost voltage VPP is retained at a constant voltage.

The precharging voltage generator 30 is composed of two differential amplifiers 30a and 30b connected at their outputs with each other. The differential amplifier 30a is supplied with the reference potential VPRREFL and the precharging voltage VPR. The differential amplifier 30b is supplied with the reference potential VPRREFL and the precharging voltage VPR. Moreover, these differential amplifiers 30a and 30b generate the precharging voltage VPR at an intermediate value between the reference voltages VPRREFL and VPRREFH.

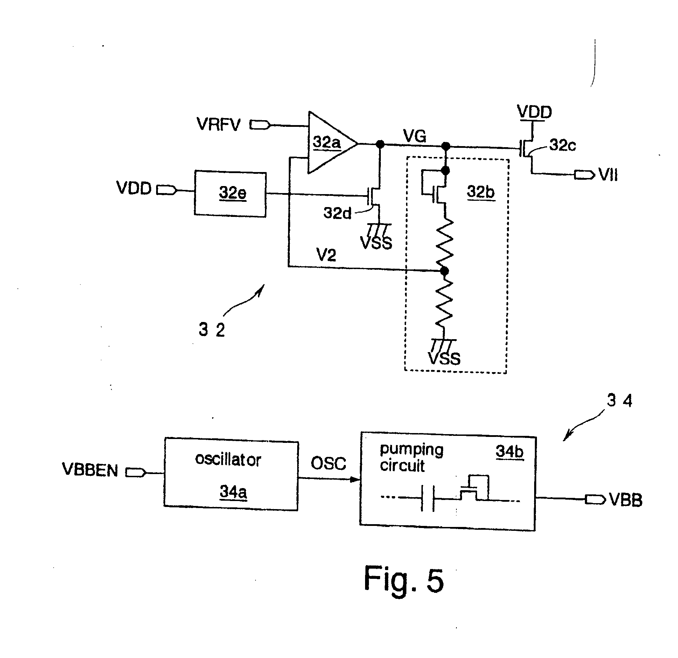

Fig. 5 shows the details of the internal supply voltage generator 32 and the substrate voltage generator 34. The internal supply voltage generator 32 is composed of a negative feedback type differential amplifier 32a, a compensating circuit 32b, a regulator 32c made of an nMOS, an nMOS 32d, and a switching circuit 32e for controlling the gate of the nMOS. The differential amplifier 32a receives the reference voltage VRFV and a voltage V2 generated by the compensating circuit 32b, and supplies a predetermined voltage to a node VG. In the compensating circuit 32b, an nMOS and resistors R3 and R4 in a diode connection are arranged in series between the node VG and the ground line VSS. The voltage V2 is generated at the connection node between the resistors R3 and R4. The regulator 32c is connected at its gate with the node VG, receives the power supply voltage VDD at its drain and generates the internal supply voltage VII at its source.

The nMOS 32d is grounded at its source and connected at its drain with the node VG. The switching circuit 32e supplies the power supply voltage VDD to a gate of the nMOS 32d during the lower power consumption mode. The nMOS 32d receives the power supply voltage VDD from the switching circuit 32e during the low power consumption mode, and fixes the node VG at the ground level.

In this internal supply voltage generator 32, when the threshold voltage of the regulator 32c is lowered due to the rise in the ambient temperature, for example, the threshold voltage of the nMOS of the compensating circuit 32b also drops, so that the voltage V2 rises. In response to the rise in the voltage V2, the differential amplifier 32a lowers the voltage of the node VG. Moreover, the source-to-drain current of the nMOS 32c is made constant so that the internal supply voltage VII is made constant.

The substrate voltage generator 34 is composed of an oscillator 34a and a pumping circuit 34b. In response to the high level of a control signal VBBEN, the oscillator 34a starts the oscillating operation to output an oscillating signal OSC. The pumping circuit 34b has a capacitor for repeating charge and discharge in response to the oscillating signal OSC from the oscillator 34a, and a diode-connected nMOS transistor connected with one end of the capacitor. The charges of a p-type substrate connected with the anode are discharged by the pumping operation, which lowers the substrate voltage VBB. Making the substrate voltage VBB negative leads to gaining some effects such as reducing the influences of a shift in the threshold voltage of the memory cells due to the substrate effect so that the characteristics of the memory cells may be improved.

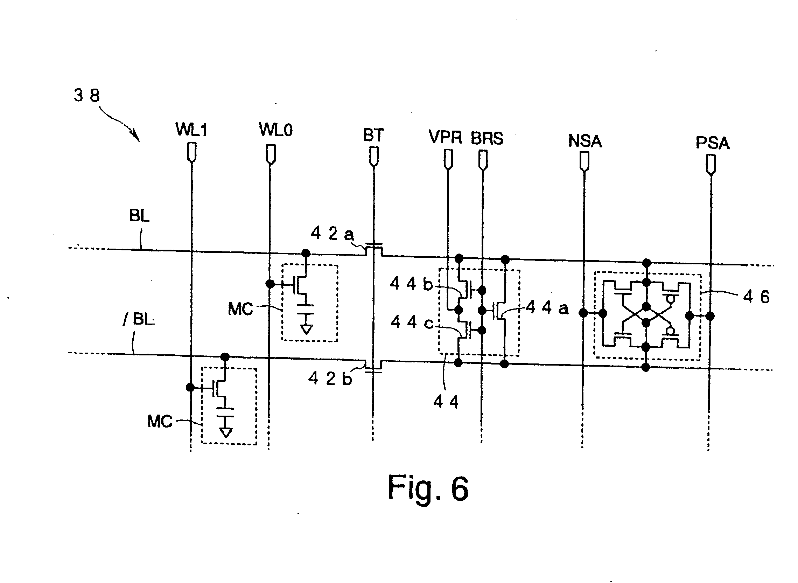

Fig. 6 shows the detail of a portion of the memory core 38.

The memory core 38 has a memory cell MC, nMOS switches 42a and 42b, a precharging circuit 44 and a sense amplifier 46.

The memory cell MC is composed of a data transferring nMOS and a capacitor. The gate of the nMOS is connected with a word line WL0 (or WL1).

The nMOS switches 42a and 42b control the connection between a bit line BL (or /BL) on the side of the memory cell MC and a bit line BL (or /BL) on the side of a sense amplifier SA. The nMOS switches 42a and 42b receive a control signal BT at their gates.

The precharging circuit 44 is composed of three nMOSes 44a, 44b and 44c. The nMOS 44a is connected at its source and drain, respectively, with the bit lines BL and /BL. The nMOSes 44b and 44c are connected at one of their sources and drains, respectively, with the bit lines BL and /BL, and are supplied at their others with the precharging voltage VPR. The nMOSes 44a and 44b and 44c receive a bit line control signal BRS at their gates.

The sense amplifier 46 is constructed by connecting the inputs and outputs of two CMOS inverters with each other. Each of these CMOS inverters is connected at its outputs individually with the bit lines /BL and BL. The source of the pMOS and the source of the nMOS of each CMOS inverter are connected with power supply lines PSA and NSA, respectively. The voltages of these power supply lines PSA and NSA individually reach the VPR level during a standby state and during the inactivation of the sense amplifiers, and respectively change to the internal supply voltage VII and the ground voltage VSS when the bit lines are amplified.

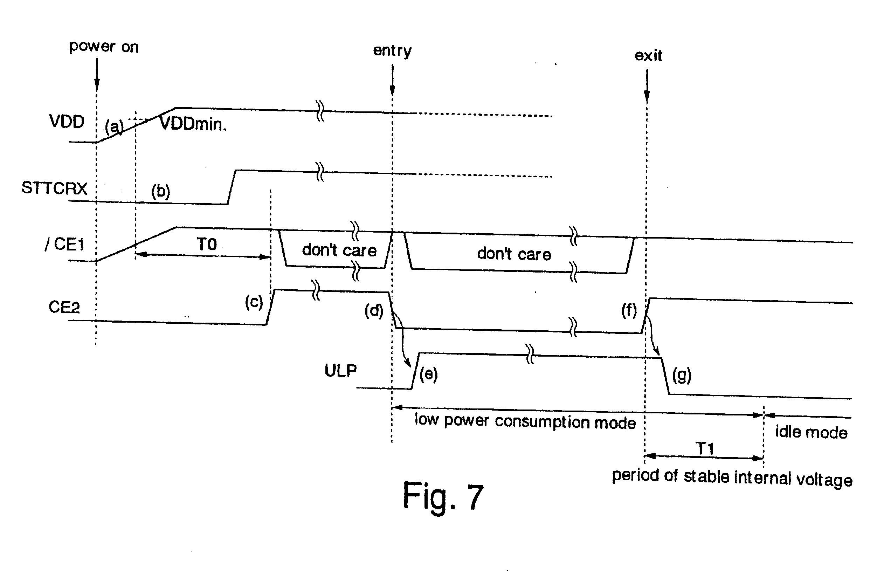

Fig. 7 shows the operations of the switch-on of the power supply, the shifting (entry) to the low power consumption mode, and the release (exit) from the low power consumption mode with regard to the aforementioned semiconductor memory device.

First of all, when the power supply is switched on, the power supply voltage VDD rises gradually (Fig. 7(a)). The VDD starter 12 shown in Fig. 3 inactivates the start signal STTCRX (to the low level) till the power supply voltage VDD reaches a predetermined voltage (Fig. 7(b)). By this control, it is possible to prevent the ULP signal from being activated due to the malfunctioning of the low power entry circuit 14 when the power supply is switched on. An exterior controller (e.g., a CPU or a memory controller) for controlling the DRAM turns the CE2 signal at the high level a predetermined time T0 after the power supply voltage VDD reaches the minimum operable voltage VDDmin (Fig. 7(c)).

After this, the DRAM becomes the standby state or executes an ordinary operation. The exterior controller turns the CE2 signal to the low level when the DRAM enters the low power consumption mode (Fig. 7(d)). The low power entry circuit 14 activates the ULP signal (to the high level) in response to the fall of the CE2 signal when the STTCRX signal is at the high level (Fig. 7(e)).

In response to the high level of the ULP signal, the low-pass filter 22 of the internal voltage generator 18 stops the supply of the power supply voltage to the reference voltage generator 24 and instead supplies the ground voltage VSS from the VSS supplying circuit 36. In response to the ground voltage VSS, the reference voltage generator 24 turns the reference voltages VPREF, VPRREFL, VPRREFH and VRFV to the ground level. The nMOS 28b of the booster 28 shown in Fig. 4 and the nMOS 32d of the internal supply voltage generator 32 shown in Fig. 5 are switched off. As a result, the booster 28, the precharging voltage generator 30, the internal supply voltage generator 32 and the substrate voltage generator 34 are inactivated to stop their operations. Thus, all the conventional circuits remaining operative during the low power consumption mode are stopped. Therefore, the power consumption in the low power consumption mode is drastically reduced as compared with the conventional.

When these circuits are inactivated, the generations of the boost voltage VPP, the precharging voltage VPR, the internal supply voltage VII and the substrate voltage VBB are stopped. However, the boost voltage VPP and the internal supply voltage VII are changed into the power supply voltage VDD by the VSS supplying circuit 36, and the substrate voltage VBB and the precharging circuit VPR are changed into the ground voltage VSS by the VSS supplying circuit 36. Therefore, the internal circuit of the main circuit unit 20 is prevented from having a leak path.

The exterior controller turns the CE2 signal to the high level when the low power consumption mode is released (Fig. 7(f)). In response to the high level of the CE2 signal, the low power entry circuit 14 inactivates the ULP signal (to the low level) (Fig. 7(g)). In response to the inactivation of the ULP signal, the low-pass filter 22 supplies the power supply voltage VDD to the reference voltage generator 24. In response to the inactivation of the ULP signal, the VDD supplying circuit 26 and the VSS supplying circuit 36 stop the supplies of the power supply voltage VDD and the ground voltage VSS. Then, the booster 28, the precharging voltage generator 30, the internal supply voltage generator 32 and the substrate voltage generator 34 are activated again to start their operations.

Here, the DRAM enters the idle mode a time T1 after the high level of the CE2 signal. This time T1 is a time required for the individual internal voltages VPP, VPR, VII and VBB to become stable.

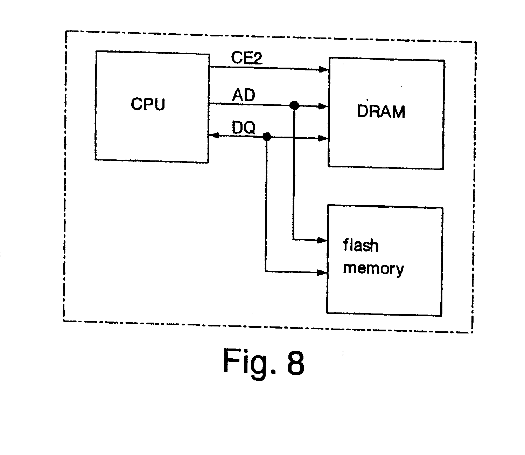

Fig. 8 shows an example in which the semiconductor memory device of the first example is employed in a cellular phone.

This cellular phone has the DRAM of this example, the CPU and the flash memory mounted on the circuit board.

The CPU controls the read/write operation of the data from/in the DRAM and the flash memory. The DRAM is employed as the work memory, and the flash memory is employed as the backup memory when the cellular phone is switched off or in the waiting state.

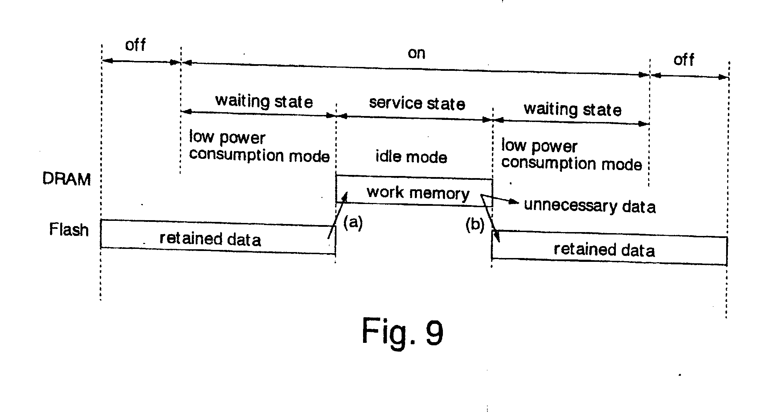

Fig. 9 shows the state of using the cellular phone shown in Fig. 8.

In this example, the DRAM is in the low power consumption mode by the control of the CPU when the cellular phone is in the waiting state. At this time, the power consumption of the DRAM is as much as that of the flash memory in the standby state.

When the cellular phone then enters the service state from the waiting state, the CPU raises the CE2 signal shown in Fig. 8 to the high level. After the DRAM entered the idle mode, the data retained in the flash memory are transferred to the DRAM (Fig. 9(a)). During the service state, the DRAM is used as the work memory. Here, the service state includes not only the state of exchanging vocal communications but also the state of transferring data.

When the service state shifts to the waiting state, those, of the data of the DRAM, necessary to be retained are saved in the flash memory (Fig. 9(b)). After this, the CPU lowers the CE2 signal to the low level and enters the DRAM to the low power consumption mode. The DRAM does not perform refresh operation in the low power consumption mode so that the unnecessary data is lost.

When the power supply is switched off, the necessary data are retained in the flash memory. By applying the DRAM of the first example to the work memory of the cellular phone, the power consumption when the cellular phone is in the waiting state is drastically reduced.

Here, the DRAM and the flash memory may be controlled not by the CPU but by a dedicated memory controller or the like. The data transfer may also be done during the service state if necessary not only when the switching over the waiting state and the service state. Moreover, the memory for backing up the data should not be limited to the flash memory but may be an SRAM. The data may be saved in a server such as the base station of the cellular phone.

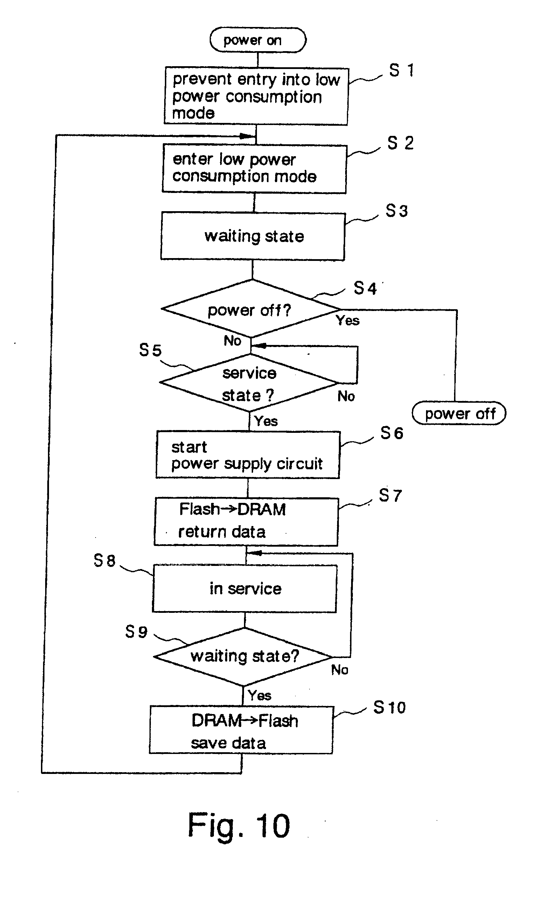

Fig. 10 is a flow chart showing a control of the cellular phone shown in Fig. 8.

At first Step S1, an entry to the low power consumption mode is prevented when the power supply is switched on. As shown in Fig. 7, specifically, the malfunction is prevented during the activation period of the STTCRX signal of the VDD starting circuit 12.

Next, at Step S2, the CPU turns the CE2 signal to the low level to enter the DRAM into the low power consumption mode. At Step S3, the cellular phone is in the waiting state.

Next, at Step S4, the CPU detects whether or not the power supply is switched off. When the power supply is switched off, the procedure is complete. When the power supply is not switched off, the procedure advances to Step S5.

At Step S5, the CPU repeats the waiting state until it becomes the service state. When it becomes the service state, the procedure advances to Step S6.

At Step S6, the CPU raises the CE2 signal to the high level to shift the DRAM from the low power consumption mode to the idle mode. Then, the individual power supply circuits 28, 30, 32 and 34 shown in Fig. 3 are started again.

Next, at Step S7, the CPU transfers the data retained in the flash memory to the DRAM (return the data).

Next, at Step S8, the service or the data transfer is performed.

At Step S9, the CPU detects whether or not the DRAM becomes the waiting state. When it does not, the procedure returns to Step S7. When it does, the procedure advances to Step S10.

At Step S10, the CPU transfers those of the data of the DRAM necessary to be retained, to the flash memory (save the data).

Then, the procedure returns to Step S2, at which the cellular phone enters again the waiting state. The DRAM enters the low power consumption mode.

In one example of a semiconductor memory device and its control method embodying the present invention, the operations of the booster 28, the precharging voltage generator 30, the internal supply voltage generator 32 and the substrate voltage generator 34 are stopped during the low power consumption mode. Therefore, the power consumption in the low power consumption mode can be drastically reduced, as compared with previously-considered devices.

In the low power consumption mode, the boost voltage VPP and the internal supply voltage VII, and the substrate voltage VBB and the precharging voltage VPR are set at the power supply voltage VDD and the ground voltage VSS, respectively. Therefore, the internal circuit of the main circuit unit 20 can be prevented from having the leak path thereby to reduce the power consumption.

By utilizing the CE2 signal existing in the previously-considered devices, the DRAM is entered to the low power consumption mode. Therefore, the kind and the number of the external terminals can be identical to those of the previously-considered terminals. As a result, the user of the DRAM is not required to drastically change the circuit due to adding the low power consumption mode.

When the power supply is switched on, the VDD starter 12 inactivates the start signal STTCRX (to the low level) until the power supply voltage VDD reaches the predetermined voltage. As a result, the low power entry circuit 14 can be prevented from any malfunction when the power supply is switched on, to prevent the ULP signal from being activated and the DRAM from entering the low power consumption mode.

When the power supply is switched on, the CE2 signal is raised to the high level the predetermined time T0 after the power supply voltage VDD reaches the minimum operating voltage VDDmin. This makes it possible to prevent the erroneous entry into the low power consumption mode when the power supply is switched on.

By applying DRAM embodying the present invention to the work memory of the cellular phone, therefore, the power consumption of the cellular phone during the waiting state can be drastically reduced. Moreover, the malfunction can be prevented.

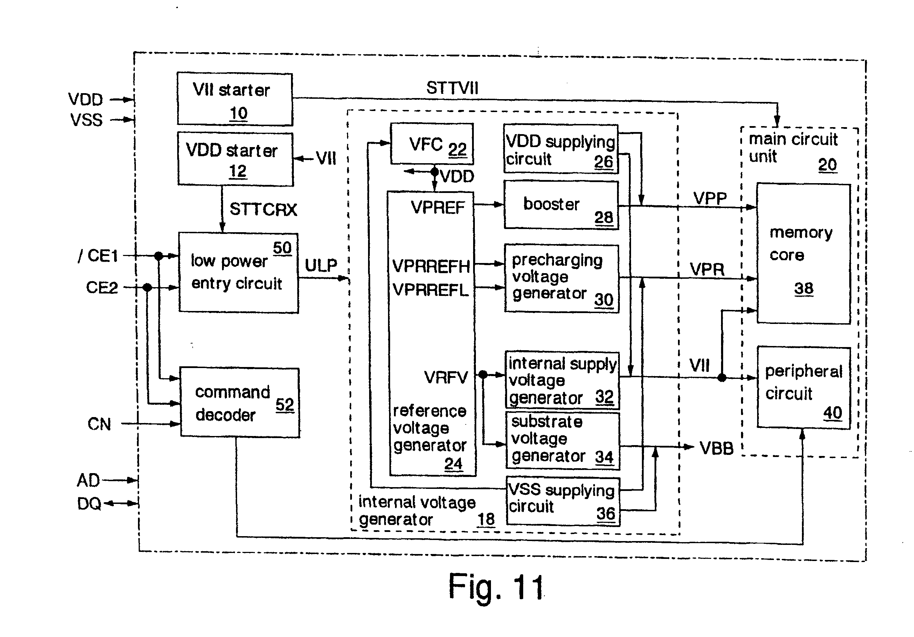

Fig. 11 shows a second example of the semiconductor memory device and its control method of the present invention. The same circuits as those described in the first example are designated by the common reference numerals, and their detailed description will be omitted.

In this example, a low power entry circuit 50 is supplied with the /CE1 signal and the CE2 signal. A command decoder 52 is supplied with the /CE1 signal, the CE2 signal and another control signal CN. The remaining construction is equivalent to that of foregoing first example.

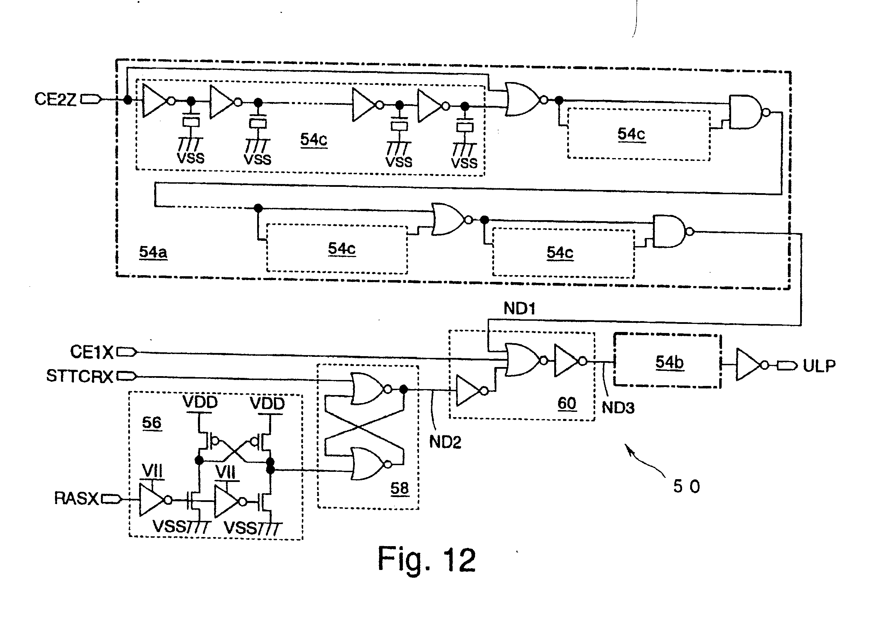

Fig. 12 shows the detail of the low power entry circuit 50.

The low power entry circuit 50 has timing adjusting circuits 54a and 54b, a level shifter 56, an RS flip-flop 58 and a combinational circuit 60.

The timing adjusting circuit 54a is formed by connecting a two-input NOR gate connected at its one input with a delay circuit 54c and a two-input NAND gate connected at its one input with the delay circuit 54c, in plurality in cascade. Each delay circuit 54c has an MOS capacity arranged between a plurality of inverters connected in cascade. The timing adjusting circuit 54a delays the falling edge of a chip enable signal CE2Z by about 100 ns and outputs it to a node ND1. The CE2Z signal is the CE2 signal which is supplied from the exterior and received at the input buffer (not shown).

The timing adjusting circuit 54b is identical to the timing adjusting circuit 54a. The timing adjusting circuit 54b delays the falling edge of the signal transmitted to a node ND3, by about 100 ns.

The level shifter 56 has two sets of pMOSes and nMOSes connected in series. Each nMOS receives at its gate the signals in phase and in inverted phase of a row address strobe signal RASX. The inverter for generating these inverted and uninverted signals of the RASX signal receives the internal supply voltage VII and the ground voltage VSS. The RASX signal is a control signal which turns to a low level when the word line is activated. The gates of the pMOSes are individually connected with the drains of the adjacent pMOSes, and the drains (or output nodes) of the nMOSes for receiving the positive logic of the RASX signal are connected with the RS flip-flop 58. Each pMOS receives the power supply voltage VDD at its source, and each nMOS receives the ground voltage VSS at its source.

The RS flip-flop 58 is composed of two two-input NOR gates. One input corresponding to an output node ND2 receives the start signal STTCRX, and the other input receives the output signal of the level shifter 56.

The combinational circuit 60 receives the low level of the nodes ND1, ND2 and the chip enable signal CE1X and it turns the output node ND3 at the low level.

The CE1X signal is generated at the input buffer (not shown) receiving the /CE1 signal supplied from the exterior and is also the negative logic signal.

The timing adjusting circuit 54b activates the ULP signal (to the high level) through the inverter about 100 ns after receiving the low level of the node ND3.

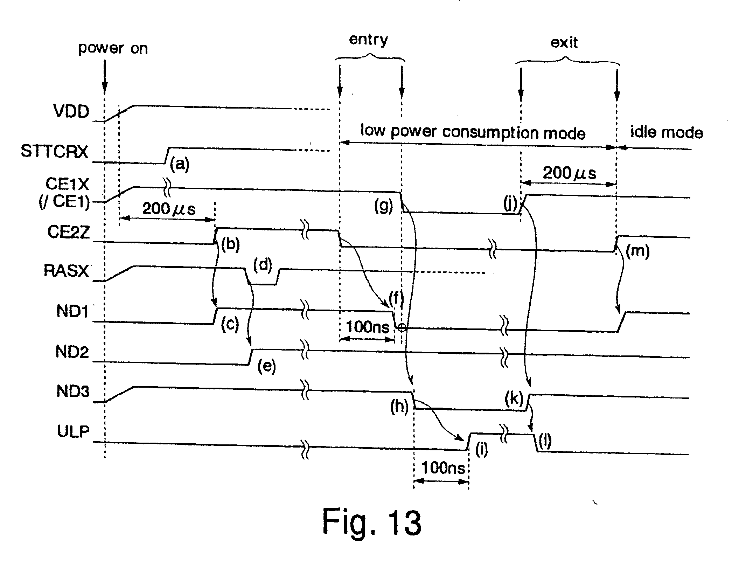

Fig. 13 shows the operations of the low power entry circuit 50.

First, when the power supply is switched on, the STTCRX signal turns to the low level so that the voltage of the /CE1 signal rises following the power supply voltage VDD. Thus, the malfunction is prevented.

A predetermined time after the power supply was switched on, the STTCRX signal turns to the high level (Fig. 13(a)). After this, the exterior controller for controlling the DRAM raises the CE2 signal to the high level (Fig. 13(b)). The timings above are identical to those of the first example. In response to the high level of the CE2Z signal, the node ND1 shown in Fig. 12 turns to the high level (Fig. 13(c)).

The initial cycle is executed to turn the RASX signal to the low level (Fig. 13(d)). In response to the low level of the RASX signal, the RS flip-flop 58 raises the node ND2 to the high level (Fig. 13(e)). After this, there are started the operations of the internal voltage generator 18 shown in Fig. 11.

Next, there is supplied an entry command for the entry into the low power consumption mode. In this example, the DRAM enters the low power consumption mode by turning the /CE1 signal to the low level a predetermined time after turning the CE2 signal to the low level.

The timing adjusting circuit 54a turns the node ND1 to the low level about 100 ns after receiving the low level of the CE2Z signal (Fig. 13(f)). 100 ns or more after the falling edge of the CE2Z signal, the CE1X signal is turned to the low level (Fig. 13(g)).

In response to the low level of the CE1Z signal and the low level of the node ND1, the combinational circuit 60 shown in Fig. 12 turns the node ND3 to the low level (Fig. 13(h)). The timing adjusting circuit 54b raises the ULP signal to the high level (Fig. 13(i)) about 100 ns after receiving the low level of the node ND3. The DRAM enters the low power consumption mode.

Thus, the DRAM enters the low power consumption mode by the command input.

At this time, the inverter of the level shifter 56 shown in Fig. 12 receives the power supply voltage VDD in place of the internal supply voltage VII. As a result, the level shifter 56 is prevented to have the leak path because the gate of the nMOS is reliably switched off.

When the low power consumption mode is released, the CE1X signal is first turned to the high level (Fig. 13(j)). The combinational circuit 60 receives the high level of the CE1X signal to turn the node ND3 to the high level (Fig. 13(k)) and the ULP signal to the low level (Fig. 13(l)). 200 is after the rising edge of the CE1X signal, the CE2Z signal is turned to the high level (Fig. 13(m)). In response to the high level of the CE2Z signal, a level of the node ND1 turns to the high level. During this period of 200 s, the internal voltage generator 18 is activated to stabilize the individual internal voltages VPP, VPR, VII and VBB at predetermined levels.

Here, the activations and inactivations of the internal voltage generator 18 are performed as in the first example. Specifically, the controls of the individual circuits in this example are identical to those of the first example excepting that the entry to and exit from the low power consumption mode are executed by the command inputs.

This example can achieve effects similar to those of the foregoing first example. In this example, moreover, the DRAM can enter the low power consumption mode and can be released from the low power consumption mode by the command inputs using the /CE1 signal and the CE2 signal.

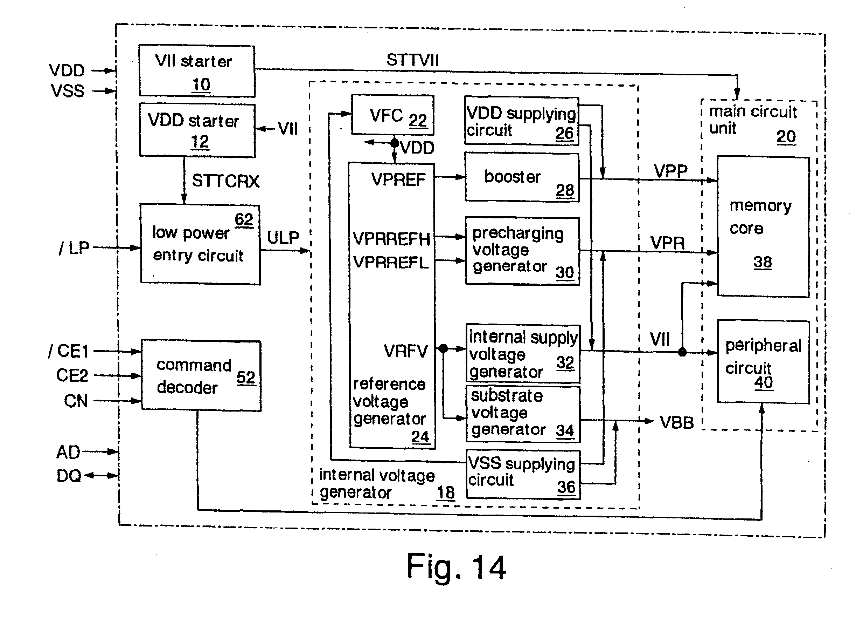

Fig. 14 shows an embodiment of the semiconductor memory device of the present invention. The same circuits as those described in the first and second examples are designated by the common reference numerals, and their detailed description will be omitted. In this embodiment, a low power entry circuit 62 receives the low power consumption mode signal /LP.

This low power consumption mode signal /LP is a signal dedicated for the DRAM to enter the low power consumption mode. The low power entry circuit 62 detects the falling edge of the /LP signal to bring the DRAM into the low power consumption mode. The command decoder 52 is supplied with the /CE1 signal, the CE2 signal and another control signal CN. The remaining constructions are similar to those of the foregoing first example.

The operation timings of the DRAM at the switch-on of the power supply and at the entry into and the exit from the low power consumption mode according to this embodiment are identical to those of the case in which the CE2 signal is replaced by the /LP signal in the timing chart shown in Fig. 7.

This embodiment can also achieve effects similar to those of the foregoing first example. In this embodiment, moreover, the DRAM can reliably enter the low power consumption mode and be released from the mode by the dedicated low power consumption mode signal /LP.

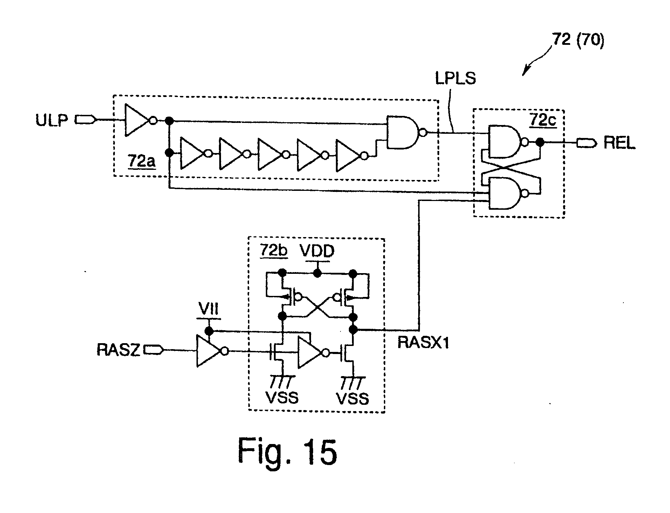

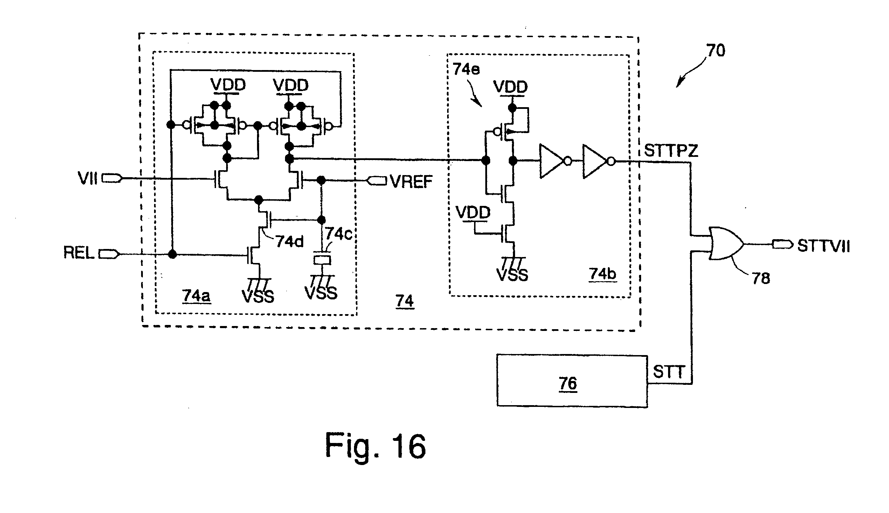

Figs. 15 and 16 show a VII starter in a third example of the semiconductor memory device and a embodiment of its control method of the present invention. The same circuits as those described in the first example are designated by the common reference numerals, and their detailed description will be omitted.

In this example, a VII starter 70 is formed in replace of the VII starter 10 in Fig. 3 (the first example). The other configuration is identical to that in Fig. 3. In other words, the DRAM of this example similar to that of Fig. 7 enters the low power consumption mode by turning the CE2 signal to low level during a high-level period of the /CE1 signal and it is released from the low power consumption mode by turning the CE2 signal to high level.

The VII starter 70 comprises a release detecting circuit 72 shown in Fig. 15 , a level detecting circuit 74, and a power-on circuit 76 shown in Fig. 16. In Figs. 15 and 16, a logic circuit is supplied with a power supply voltage VDD except the circuit with a power supply voltage indicated.

A release detecting circuit 72 comprises a detecting circuit 72a, a level shifter 72b, and a flip-flop 72c. The detecting circuit 72a receives a low power signal ULP shown in Fig. 3 and outputs the low level of a pulse LPLS in synchronization with the falling edge of the ULP signal. The level shifter 72b converts the high level voltage (internal power supply voltage VII) of a row address strobe signal RASZ to the external power supply voltage VDD and outputs a row address strobe signal RASX1 having inverted logic. The level shifter 72b is identical to the level shifter 56 shown in Fig. 12. Receiving a low pulse from the detecting circuit 72a, the flip-flop 72c turns a release signal REL to high level, and receiving a low level (RASZ = high level) from the level shifter 72b, it turns the release signal REL to low level.

In Fig. 16, a level detecting circuit 74 comprises a differential amplifier 74a including a current mirror circuit and an inverter row 74b which includes an odd number of inverters and receives the output of the differential amplifier 74a. The differential amplifier 74a is activated during the high level of the release signal REL, compares an internal power supply voltage VII with a reference voltage VREF, and outputs the comparison result to an inverter row 74b. A generator for the internal power supply voltage VII generates a constant value of the internal power supply voltage VII independent of the fluctuation of the power supply voltage VDD supplied from the exterior. On the other hand, the reference voltage VREF varies depending on the fluctuation of the power supply voltage VDD.

The output voltage of the differential amplifier 74a goes low when the internal power supply voltage VII is lower than the reference voltage VREF. The differential amplifier 74a comprises a MOS capacitor 74c for receiving the reference voltage VREF in order to prevent its response to insignificant fluctuation of the reference voltage VREF. In addition, an nMOS 74d for receiving the reference voltage VREF is disposed on a path to a ground line VSS in order to limit the amount of current flow to the ground line VSS and reduce the power consumption during the operation of the differential amplifier 74a. The nMOS 74d operates as high-resistance. An inverter 74e in the initial stage of the inverter row 74b has an nMOS connected in serial so as to have the logic threshold of an input signal in conformity with the output of the differential amplifier 74a.

A power-on circuit 76 turns a start signal STT to high level during a predetermined period since the power supply voltage is supplied to the DRAM. An OR circuit 78, upon receiving the high level of a start signal STTPZ or the high level of the start signal STT, outputs the high level of a start signal STTVII (reset signal). The start signal STTVII, similarly to that of Fig. 3, is supplied to the main circuit unit 20 and initializes a predetermined internal circuit.

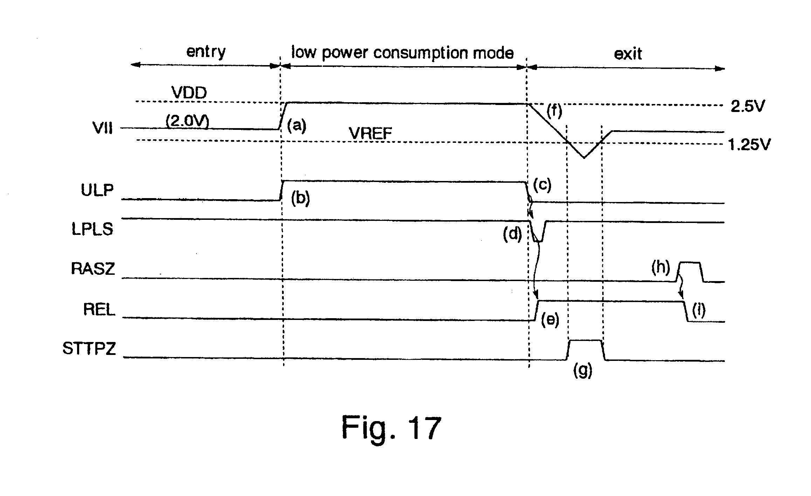

Fig. 17 shows the operation timings of the above-described DRAM at the time of entry to and exit from the low power consumption mode.

Firstly, when the CE2 signal (not shown) is turned to low level, the DRAM enters the low power consumption mode by a low power entry circuit 14 shown in Fig. 3 and a generator for the internal power supply voltage VII terminates its operation. The internal power supply voltage VII (for example, 2.0V in a normal operation) becomes equal to the power supply voltage VDD (for example, 2.5V) (Fig. 17(a)) and an ULP signal turns to high level(Fig. 17(b)).

Subsequently, the CE2 signal being turned to high level, the DRAM is released from the low power consumption mode and the ULP signal turns to low level(Fig. 17(c)). In other words, the DRAM is released from the low power consumption mode in accordance with the level of the CE2 signal received during the low power consumption mode. The exit from the low power consumption mode is controlled by the low power entry circuit 14 shown in Fig. 3.

Receiving the falling edge of the ULP signal, the detecting circuit 72a in Fig. 15 turns an LPLS signal to low level (pulse)(Fig. 17(d)). Receiving the low level of the LPLS signal, the flip-flop 72c in Fig. 15 turns the REL signal to high level (Fig. 17(e)).

Due to the exit from the low power consumption mode, a power supply line of the internal power supply voltage VII and that of the power supply voltage VDD are disconnected and simultaneously the generator for the internal power supply voltage VII initiates its operation. The internal power supply voltage VII goes low for some time from the initiation of the generator(Fig. 17(f)). The differential amplifier 74a in Fig.16 outputs low level to the inverter row 74b when the internal power supply voltage VII is lower than the reference voltage VREF(for example, 1.25V). The inverter row 74b, upon receiving the low level of the differential amplifier 74a, outputs the high level of the STTPZ signal(Fig. 17(g)). The OR circuit 78, upon receiving the high level of the STTPZ signal, turns a start signal STTVII to high level. The start signal STTVII functions as a reset signal and a predetermined internal circuit of the main circuit unit 20 shown in Fig.3 is initialized.

After the exit from the low power consumption mode, by issuing an operation command to the DRAM, the RASZ signal is turned to high level(Fig. 17(h)) and the REL signal to low level(Fig. 17(i)). The differential amplifier 74a is inactivated due to the low level of the REL signal.

As described above, at the time of the exit from the low power consumption mode, the initialization of the internal circuit prevents it from malfunctioning when the operation of the internal circuit supplied with the internal power supply voltage VII cannot be ensured because of the internal power supply voltage VII lower than a predetermined voltage (reference voltage VREF).

In this example above, when the state of the CE2 signal received during the low power consumption mode indicates exit of the low power consumption mode, the low power consumption mode is released. This allows the easy exit of a chip from the low power consumption mode by the control signal from the exterior.

At the exit from the low power consumption mode, the start signal STTVII which is a reset signal for initializing an internal circuit is activated during a period where the internal power supply voltage VII is lower than the reference voltage VREF. This makes it possible to securely reset the internal circuit and prevent the malfunction of the internal circuit when the low power consumption mode shifts to the normal operating mode.

One control signal(CE2 signal)enables the entry of a chip to the low power consumption mode and the exit of a chip from the low power consumption mode.

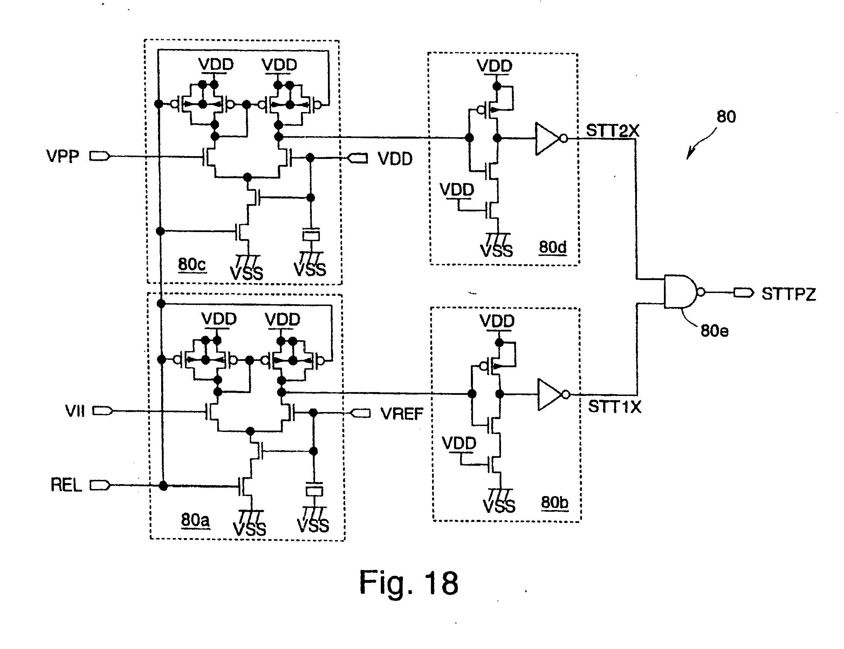

Fig. 18 shows a level detecting circuit 80 in a fourth example of the semiconductor memory device and its control method of a third example of the present invention. The same circuits as those described in the first and third examples are designated by the common reference numerals, and their detailed description will be omitted.

In this example, a level detecting circuit 80 is formed in replace of the level detecting circuit 74 described in the third example. The other configuration is identical to that in the third example.

The level detecting circuit 80 comprises: a differential amplifier 80 for comparing the internal power supply voltage VII with the reference voltage VREF; an inverter row 80b including an even number of inverters; a differential amplifier 80c for comparing a boost voltage VPP of a word line (not shown) with the power supply voltage VDD from the exterior; an inverter row 80d including an even number of inverters; and an NAND gate 80e. The boost voltage VPP generated by a booster is formed inside of the chip. The differential amplifiers 80a and 80c are identical to the differential amplifier 74a in Fig. 16 and are activated upon receipt of the high level of the REL signal. The inverter rows 80b and 80d are constructed of the inverter in the initial stage and the inverter in the second stage of the inverter row 74b in Fig. 16. The inverter row 80b receives the output of the differential amplifier 80a and outputs the received logic level to a NAND gate 80e as a start signal STT1X. The inverter row 80d receives the output of the differential amplifier 80c and outputs the received logic level to the NAND gate 80e as a start signal STT2X. The NAND gate 80e operates as an OR circuit of negative logic and outputs a start signal STTPZ.

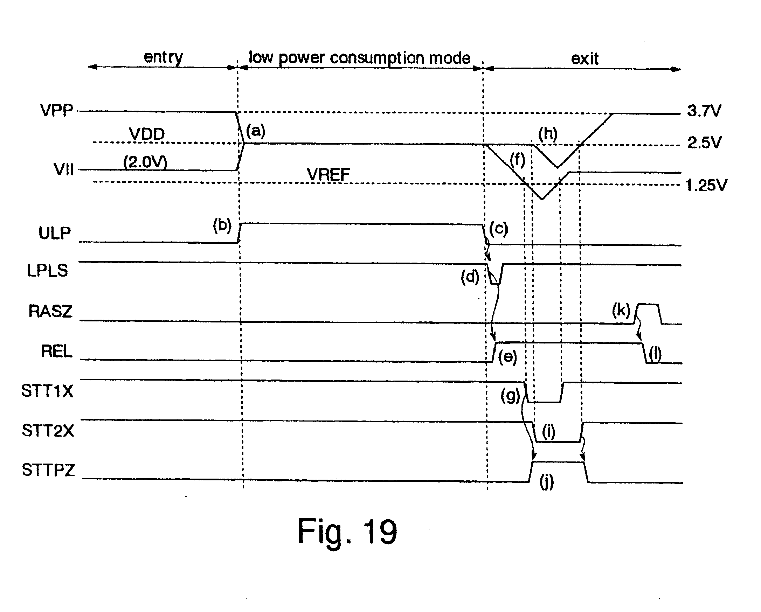

Fig. 19 shows the operation timings of the above-described DRAM at the time of entry to and exit from a low power consumption mode.

Firstly, when the CE2 signal(not shown) is turned to low level, the DRAM enters the low power consumption mode and a generator for the internal power supply voltage VII and a generator for the boost voltage VPP terminate their operation. The internal power supply voltage VII (for example, 2.0V in the normal operation) and the boost voltage VPP (for example, 3.7V in the normal operation) become equal to the power supply voltage VDD (for example, 2.5V)(Fig. 19(a)) and an ULP signal turns to high level (Fig. 18(b)).

Subsequently, the CE2 signal being turned to high level, the DRAM is released from the low power consumption mode and the ULP signal turns to low level (Fig. 19(c)). The LPLS signal is turned to low level (pulse) as well as in Fig. 17 (Fig. 19(d)) and the REL signal is turned to high level (Fig. 19(e)).

Due to the exit from the low power consumption mode, the power supply line of the internal power supply voltage VII and the power supply line of the power supply voltage VDD are disconnected and the generator for the internal power supply voltage VII initiates its operation. The internal power supply voltage VII goes low for some time from the initiation of the generator(Fig. 19(f)). The low level of the STT1X signal is output during a period where the internal power supply voltage VII is lower than the reference voltage VREF (for example, 1.25V) (Fig. 19(g)). Similarly, the connection between the power supply line of the boost voltage VPP and that of the power supply voltage VDD is disconnected and the generator for the boost voltage VPP initiates its operation. The boost voltage VPP goes low for some time from the initiation of the generator (Fig. 19(h)). The low level of the STT2X signal is output during a period where the boost voltage VPP is lower than the power supply voltage VDD (Fig. 19(i)).

The NAND gate 80e in Fig. 18 outputs the high level of the STTPZ signal during a period where the STT1X signal or the STT2X signal is at low level (Fig. 19(j)). During the high level of the STTPZ signal, the start signal STTVII (Fig. 16)is turned to high level. The start signal STTVII functions as a reset signal and initializes a predetermined internal circuit of the main circuit unit 20 shown in Fig.3.

After the exit from the low power consumption mode, the DRAM initiates its operation, thereby the RASZ signal being turned to high level (Fig. 19(k)) and the REL signal to low level(Fig. 19(l)) as well as in Fig. 17. The differential amplifier 80a and 80 are inactivated due to the low level of the REL signal.

This example can also achieve effects similar to those of the foregoing third example. In this example, moreover, at the time of the exit from the low power consumption mode a start signal STTVII for initializing an internal circuit is activated during a period where the boost voltage VPP internally generated is lower than the power supply voltage VDD from the exterior. Specifically, at the time of the exit from the low power consumption mode, the start signal STTVII for initializing an internal circuit is activated during a period where at least one of the internal power supply voltage VII and is/are respectively lower than the reference voltage VREF and the power supply voltage VDD. This makes it possible to securely reset the internal circuit and prevent the malfunction of the internal circuit when the low power consumption mode shifts to the normal operating mode.

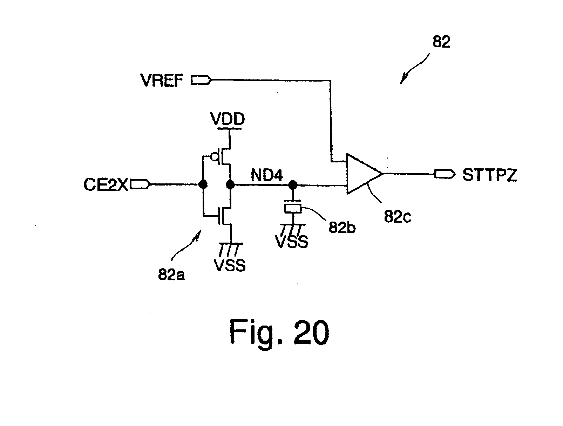

Fig. 20 shows a start signal generator of the semiconductor memory device in a fifth example and its control method of a fourth example of the present invention. The same circuits as those described in the first and third examples are designated by the common reference numerals, and their detailed description will be omitted.

In the DRAM of this example, a start signal generator 82 is formed in replace of the release detecting circuit 72 and the level detecting circuit 74 described in the third example. The other configuration is identical to that in Fig.3 (the first example).

The start signal generator 82 are constructed of a CMOS inverter 82a for receiving a CE2X signal (internal signal) which is an inverted CE2 signal, a MOS capacitor 82b connected with the output of the CMOS inverter 82a, and a differential amplifier 82c for receiving the input of the CMOS inverter 82a and the reference voltage VREF. The differential amplifier 82c comprising a current mirror circuit, turns a start signal STTPZ to high level when the voltage of a node ND4 is lower than the reference voltage VREF.

The pMOS of the CMOS inverter 82a has a long channel length to have high on-resistance. A CR time constant circuit is constructed of the pMOS of the CMOS inverter 82a and the MOS capacitor 82b. Utilizing the on-resistance of a transistor to construct the CR time constant circuit allows the layout to be reduced in size than the case of utilizing diffused resistance.

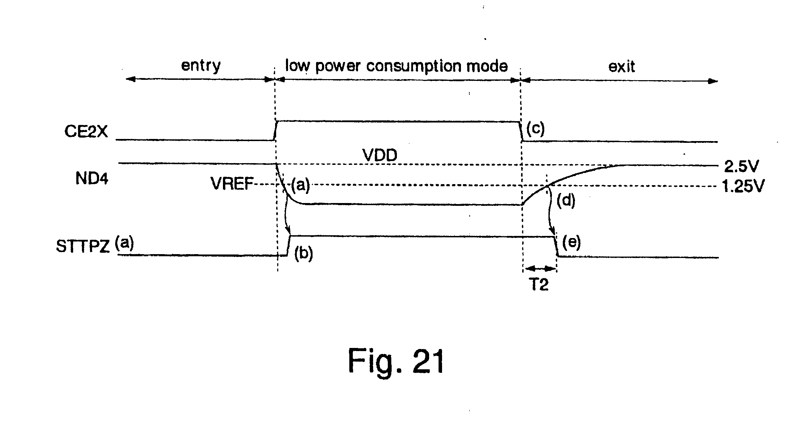

Fig. 21 shows the operation timings of the above-described DRAM at the time of entry to and exit from the low power consumption mode.

Firstly, when the CE2 signal (not shown) is turned to low level, the CE2X signal is turned to high level and the DRAM enters the low power consumption mode. A generator for the internal power supply voltage VII and a generator for the boost voltage VPP terminate their operation. The CMOS inverter 82a in Fig. 20 upon receiving the high level of the CE2X signal, turns the nMOS on and a node ND4 to low level (Fig. 21(a)). The differential amplifier 82c turns a STTPZ signal to high level when the voltage of the node ND4 is lower than the reference voltage VREF (Fig. 21(b)).

Subsequently, the CE2 signal being turned to high level and the CE2X signal to low level, the DRAM is released from the low power consumption mode (Fig. 21(c)). The CMOS inverter 82 in Fig. 20 upon receiving the low level of the CE2X signal, turns the pMOS on and the node ND4 to high level (Fig. 21(d)). At this time the voltage of the node ND4 gradually rises in accordance with the time constant determined by the on-resistance of the pMOS and the CMOS capacitor. The differential amplifier 82c turns the STTPZ signal to low level when the voltage of the node ND4 is higher than the reference voltage VREF (Fig. 21(e)).

Consequently, the STTPZ signal(reset signal) is activated (high level) and the internal circuit is initialized during a period T2 from the exit from the low power consumption mode. The period T2 is set after the exit from the low power consumption mode in correspondence with a period where the internal power supply voltage VII is lower than a predetermined voltage so that the operation of the internal circuit supplied with the internal power supply voltage VII can not be ensured. In other words, the start signal generator 82 operates as a timer for determining the length of the period T2.

This example can also achieve effects similar to those of the foregoing third example. In this example, moreover, at the time of the exit from the low power consumption mode the start signal generator 82 is operated as a timer to generate the STTPZ signal and the internal circuit is initialized during the period T2 after the exit from the low power consumption mode.

This makes it possible to reliably reset the internal circuit and prevent the malfunction of the internal circuit when the low power consumption mode shifts to the normal operating mode.

Since the start signal generator 82 is operated as a CR time constant circuit, it is possible to set the period T2 based on the propagation delay time of a signal propagated to the CR time constant circuit. This makes it possible to set a period necessary for resetting the internal circuit by a simple circuit.

The on-resistance of the pMOS is utilized to form the CR time constant circuit so that the layout of the start signal generator 82 can be reduced in size.

In the example described above, the present invention is applied to the DRAM. However, the present invention is not limited to this example. For example, the present invention may be applied to a semiconductor memory such as SDRAMs (Synchronous DRAMs), DDR SDRAMs (Double Data Rate SDRAMs), or FCRAMs (Fast Cycle RAMs).

A semiconductor fabrication process to which the present invention is applied is not restricted to the CMOS process, but it may well be a Bi-CMOS process.

The foregoing second example has been described on an example in which the low power entry circuit 50 is formed by connecting the plurality of delay circuits 54c in series. However, the present invention should not be limited thereto but may form the low power entry circuit by using a latch circuit to be controlled by the STTCRX signal, for example. In this modification, the circuit scale is reduced.

The foregoing embodiment has been described on the example using the dedicated low power consumption mode signal /LP. This DRAM can be supplied even to the user requiring no low power consumption mode, for example, by pulling up the /LP signal on the chip and providing no terminal for the /LP signal. This /LP signal may be connected with the power supply voltage VDD by bonding or blowing the fuse. Alternatively, the /LP signal may be connected with the power supply voltage VDD by selecting photo masks of a wiring layer.

The foregoing fourth example has been described on an example of the comparison between the boost voltage VPP and the power supply voltage VDD. However, the present invention is not limited to this example, for example, the boost voltage VPP may well be compared with the reference voltage VREF which is generated by stepping down the power supply voltage VDD.

The foregoing fifth example has been described on an example of operating the start signal generator 82 as a timer for determining the length of the period T2 at the exit from the low power consumption mode and activating a STTPZ signal(reset signal) for initializing an internal circuit during the period T2.

The present invention is not limited to this example. For example, at the time of the exit from the low power consumption mode, a counter operating in normal operation is operated as a timer so as to count a predetermined number. The reset signal for initializing an internal circuit may well be activated during a period where the counter counts the number. A refresh counter indicating the refresh address of memory cells or the like can be used as the counter.

The invention is not limited to the above embodiment and various modifications may be made without departing from the scope of the invention. Any improvement may be made in part or all of the components.

## Claims

1. A semiconductor device comprising:
a first memory (DRAM) including dynamic memory cells, the first memory being capable to enter a low power consumption mode in which the dynamic memory cells do not retain data therein by prohibiting refresh operations, and the first memory having a data terminal (DQ); and
a second memory (Flash) including flash memory cells, having a data terminal (DQ) which is connected with the data terminal of the first memory, in which
the first memory is capable to enter the low power consumption mode in response to a change from a first level to a second level of an external control signal (/LP) received at an external terminal, the first memory being capable to receive the external control signal through a signal line, capable to continuously receive a power supply voltage (VDD) during the low power consumption mode, and capable to exit the low power consumption mode in response to a change from the second level to the first level of the external control signal,
**characterised by**
an internal voltage generator (18) for generating an internal voltage from an external voltage and for supplying the internal voltage to an internal circuit, the internal voltage generator being deactivated in the low power consumption mode where the external voltage is applied to the internal circuit.

2. The semiconductor device according to claim 1, wherein
the first memory (DRAM) includes a coupling terminal for coupling the external terminal to the signal line, and
the low power consumption mode is capable to be entered in response to the external control signal (/LP) supplied from the outside of the first memory through the coupling terminal by coupling the external terminal to the coupling terminal and is invalidated by clamping the external terminal to the first level.

## Patentansprüche

1. Halbleitervorrichtung, enthaltend:
einen ersten Speicher (DRAM), der dynamische Speicherzellen enthält, wobei der erste Speicher geeignet ist, in einen Modus mit niedrigem Energieverbrauch einzutreten, in dem die dynamischen Speicherzellen in sich keine Daten behalten, indem Auffrischungsoperationen verhindert werden, und der erste Speicher ein Datenterminal (DQ) hat; und
einen Flash-Speicherzellen enthaltenden zweiten Speicher (Flash), der ein Datenterminal (DQ) hat, das mit dem Datenterminal des ersten Speichers verbunden ist, wobei
der erste Speicher geeignet ist, in den Modus mit niedrigem Energieverbrauch in Abhängigkeit von einer Änderung eines externen Steuersignals (/LP) von einem ersten Pegel zu einem zweiten Pegel einzutreten, das an einem externen Terminal erhalten wurde, wobei der erste Speicher geeignet ist, ein externes Signal durch eine Signalleitung zu erhalten, geeignet ist, kontinuierlich eine Energieversorgungsspannung (VDD) während des Modus mit niedrigem Energieverbrauch zu erhalten, und geeignet ist, den Modus mit niedrigem Energieverbrauch in Abhängigkeit von einer Änderung des externen Steuersignals von dem zweiten Pegel zu dem ersten Pegel zu verlassen,
**gekennzeichnet durch**
einen internen Spannungsgenerator (18) zum Erzeugen einer internen Spannung von einer externen Spannung und, um die interne Spannung einer internen Schaltung zuzuführen, wobei der interne Spannungsgenerator in dem Modus mit niedrigem Energieverbrauch deaktiviert ist, in dem die externe Spannung der internen Schaltung zugeführt wird.

2. Halbleitervorrichtung nach Anspruch 1, wobei
der erste Speicher (DRAM) ein Kopplungsterminal zum Koppeln des externen Terminals mit der Signalleitung enthält, und
der Modus mit niedrigem Energieverbrauch geeignet ist, dass in ihn in Abhängigkeit von dem externen Steuersignal (/LP) eingetreten wird, das von außerhalb des ersten Speichers durch das Kopplungsterminal durch Koppeln des externen Terminals mit dem Kopplungsterminal zugeführt wird und durch Halten des externen Terminals auf dem ersten Pegel außer Kraft gesetzt wird.

## Revendications

1. Dispositif à semi-conducteurs comprenant :
une première mémoire (DRAM) comprenant des cellules de mémoire dynamiques, la première mémoire étant capable d'entrer dans un mode à faible consommation d'énergie, dans lequel les cellules de mémoire dynamiques ne retiennent pas les données en empêchant les opérations de rafraîchissement, et la première mémoire ayant une borne de données (DQ) ; et
une seconde mémoire (Flash) comprenant des cellules de mémoire flash, ayant une borne de données (DQ), qui est connectée à la borne de données de la première mémoire, où
la première mémoire est capable d'entrer dans le mode à faible consommation d'énergie en réponse à un changement d'un premier niveau à un second niveau d'un signal de commande externe (/LP) reçu au niveau d'une borne externe, la première mémoire étant capable de recevoir le signal de commande externe par l'intermédiaire d'une ligne de signal, capable de recevoir en continu une tension d'alimentation électrique (VDD) au cours du mode à faible consommation d'énergie, et étant capable de quitter le mode à faible consommation d'énergie en réponse à un changement du second niveau au premier niveau du signal de commande externe,
**caractérisé par**
un générateur de tension interne (18) pour générer une tension interne à partir d'une tension externe et pour délivrer la tension interne à un circuit interne, le générateur de tension interne étant désactivé dans le mode à faible consommation d'énergie où la tension externe est appliquée au circuit interne.

2. Dispositif à semi-conducteurs selon la revendication 1, dans lequel
la première mémoire (DRAM) comprend une borne de couplage pour coupler la borne externe à la ligne de signal, et
le mode à faible consommation d'énergie est capable d'être activé en réponse au signal de commande externe (/LP) délivré depuis l'extérieur de la première mémoire à travers la borne de couplage en couplant la borne externe à la borne de couplage, et est invalidé en fixant la borne externe au premier niveau.
